# EUROPEAN PATENT APPLICATION

(11) **EP 2 088 630 A1**
(43) Date of publication of application: **12.08.2009**
(21) Application number: 08101435.9
(22) Date of filing: 08.02.2008
(51) Int. Cl.: H01L 31/0216, H01L 31/18, C23C 14/35, C23C 14/56, C23C 14/06, C23C 14/02, H01L 21/02

(54) **Photovoltaic device comprising a sputter deposited passivation layer as well as method and apparatus for producing such a device**

(71) Applicant: Applied Materials, Inc., Santa Clara, CA 95054 (US)
(72) Inventor: Trassl, Roland, 35392 Gießen (DE); Schramm, Sven, 63741 Aschaffenburg (DE); Wolke, Winfried, 79110 Freiburg (DE); Catoir, Jan, 79110 Freiburg (DE)
(74) Representative: Lang, Christian

(57) **Abstract**

The present invention refers to a method of producing a photovoltaic device having at least one semiconductor unit comprising the following steps:
- cleaning of at least one surface of the semiconductor unit by etching,
- drying of the at least one surface of the semiconductor unit in a substantially oxygen-free or oxygen-depleted environment and
- depositing of a passivation layer on the at least one surface

as well as to a device for carrying out such a method and to photovoltaic devices produced by this method.

## Description

### BACKGROUND OF THE INVENTION

### FIELD OF THE INVENTION

The present invention refers to a method of producing a photovoltaic device as well as to an apparatus for carrying out such a method and to a photovoltaic device produced thereby.

### PRIOR ART

Due to pollution concerns and the increased energy consumption photovoltaic devices, also named as solar cells, are of increasing interest. Solar cells or photovoltaic devices are able to produce electric energy from sunlight impinging onto the solar cell or photovoltaic device. The more energy is produced by the solar cell for a given amount of light impinging onto the solar cell the better the efficiency of the solar cell. Accordingly, it is a general object to increase the efficiency of photovoltaic devices.

Solar cells comprise at least two semiconducting areas of different conductivity type to form a semiconductor unit. Most solar cells comprise a semiconductor unit made from silicon having a n-doped area as well as a p-doped area. At the interface of the n-doped area having n-type conductivity and the p-doped area having p-type conductivity a semiconductor junction is formed where positive and negative charge carriers generated by impinging light are separated. The areas being adjacent to the p-n-junction may also be designated as emitter and basis. By means of metallic contacts connected to the emitter and the basis the charge carriers can be led away and thus, electric energy can be generated.

One source of electrical losses of solar cells is re-combination of charge carriers at surfaces and interfaces, for example grain boundaries, of the semiconducting material.

In order to improve efficiency of the solar cell, it is known from prior art to reduce the probability of re-combination of charge carriers at the surfaces of the semiconductor unit. Accordingly, so-called passivation layers are arranged at the surfaces of the semiconductor unit. Such passivation layers may be formed of amorphous silicon, hydrogenated silicon nitride or hydrogenated silicon oxide. In particular, the hydrogen content plays an important role, since the hydrogen reduces the number of free silicon bonds and therefore reduces the number of re-combination locations. Accordingly, hydrogen is also advantageous for reducing the number of re-combination locations inside the semiconductor material, like silicon, if multi- or poly-crystalline silicon is used. The grain boundaries of the multi-crystalline or poly-crystalline silicon also serve as re-combination locations and the hydrogen may also reduce the number of free silicon bonds there. Moreover, hydrogen may also reduce the detrimental effect of metallic impurities which may also provide re-combination locations.

A further reason for poor efficiency of a solar cell can be the reflection of the impinging light at the surface of the solar cell or the corresponding semiconductor unit, respectively. In order to reduce the reflection of the impinging light it is known to provide anti-reflection coatings on the surface of the solar cell were the light is impinging. Such an anti-reflection coating may be formed by a single or a plurality of thin transparent layers. Such an anti-reflection coating may be formed of hydrogenated silicon nitride which can also be used as a passivation layer. Accordingly, hydrogenated silicon nitride is widely used as passivation layer as well as antireflection coating for solar cells.

Prior to coating of the semiconductor unit with a passivation layer or an anti-reflection coating the semiconductor unit is cleaned by an etching step in order to remove contaminations like silicon dioxide formed for example on a silicon semiconductor unit and to create a defined interface between the semiconductor unit and the passivation layer or anti-reflection coating. Moreover, etching may be used for structuring of the surface of the semiconductor unit in order to further reduce reflection losses. After etching the semiconductor unit has to be rinsed and dried to remove all etchant.

Such treatment of surfaces of a semiconductor unit by etching, rinsing, drying and/or other methods is described for example in the patent documents US 4,705,760, US 5,727,578 and US 5,911,837.

US 4,705,760 describes a method of making a semiconductor device wherein prior to a deposition of a passivation layer the surface of the semiconductor is treated with an aqueous ammonia fluoride-hydrogen fluoride solution and is subjected to a plasma in an oxygen-free, nitrogen-containing atmosphere at a temperature between about 25 ° C and 200 ° C. Due to this treatment the photo detector formed by the semiconductor device shows increased performance characteristics. However, the plasma treatment causes high effort.

Further methods for treating and drying a surface of semiconductor wafers described in the above-mentioned documents comprise rinsing of the surface with an aqueous fluid and removing of the aqueous fluid by a so-called organic drying solvent. However, such methods comprise oxidising of the surface due to an ozone treatment for removing the organic drying solvent which is also very laborious.

According to prior art, the passivation layer of hydrogenated silicon nitride SiN:H may be deposited after the above-mentioned cleaning of the semiconductor surface by a plasma enhanced chemical vapor deposition (PECVD), low pressure chemical vapor deposition (LPCVD) and atmospheric pressure chemical vapor deposition (APCVD) using silane or dichlorsilane and ammonia as reactive gases (K. Hezel and R. Schörner, Interface States and Fixed Charges in MNOS Structures with APCVD and Plasma Silicon Nitride, J. Electrochem. Soc. 131 (1984) 1679-1683; T. Pernau, Hydrogen Passivation and Silicon Nitride Deposition Using an Integrated LPCVD Process, In Proc. 16th European Photovoltaic Solar Energy Conference (2000) and R.S.R. Hezel, Plasma Si nitride - A promising dielectric to achieve high quality silicon MIS/IL solar cells, J. Appl. Phys. 52 (1981) 3076-3079).

In addition to chemical vapor deposition processes, it is known from prior art that anti-reflection coatings or passivation layers formed of hydrogenated silicon nitride can also be produced by reactive sputtering (s. W. Wolke A. Jäckle, R. Preu, S. Wieder, M. Ruske, SiN:H anti-reflection coatings for c-Si solar cells by large scale inline sputtering, In Proc. 19th European Photovoltaic Solar Energy Conference, Paris (2004)). A sputter deposition of the hydrogenated silicon nitride has the advantage that the hydrogen content can be better controlled during deposition and a high hydrogen intake into the passivation layer and/or the adjacent semiconductor can be reached. However, due to so-called blistering at the interface between the semiconductor unit formed of silicon and the passivation layer formed of hydrogenated silicon nitride (SiN:H) the amount of hydrogen to be introduced into the passivation layer as well as the semiconductor unit is limited.

### DISCLOSURE OF THE INVENTION

### OBJECT OF THE INVENTION

It is an object of the present invention to further improve the efficiency of solar cells. In particular, it is an object of the present invention to increase the hydrogen content of the passivation layer and/or the semiconductor unit. Moreover, a method or a device to achieve such objects should be easy to manufacture or simple to be carried out, respectively.

### TECHNICAL SOLUTION

The above-mentioned objects are achieved by a method according to claim 1 as well as an apparatus according to claim 26 and photovoltaic devices according to claims 27 and 31. Preferred embodiments are subject matter of the dependent claims.

In order to improve the efficiency of a photovoltaic device or a solar cell the invention suggests a method of producing a photovoltaic device comprising at least one cleaning step, at least one drying step and at least one deposition step.

The cleaning step refers to the removal of contaminations and undesired substances in general at the surface of the semiconductor unit forming the photovoltaic device. The at least one surface to be cleaned by the cleaning step is a surface were a passivation layer and/or anti-reflection coating is to be deposited for the purpose of decreasing re-combination of charge carriers. Accordingly, only one surface of the semiconductor unit, for example the surface were the light is impinging on the photovoltaic device, or several or all surfaces of the semiconductor unit may be cleaned and afterwards coated with a passivation layer or anti-reflection coating.

The cleaning of the surface is performed by etching. The expression etching covers every method of material removal of the surface by a chemical and/or physical reaction on an atomic scale. Different types of etch processes may be used, like chemical dry etching, chemical wet etching and/or a plasma etching, a specific form of the chemical dry etching supported by a plasma.

Physical etching like ion beam etching uses also an etching medium, but the way of removing the material is predominantly characterized by removing of material through mechanical impact of atoms or ions. In addition, processes using a mixture of chemical and physical etching may be used, like plasma etching.

Cleaning of the surface by etching allows generating of a complete clean surface, since even strongly adhering contaminations are expected to be dissolved by the etching medium.

In a preferred embodiment of the present invention etching of a semiconductor unit, especially a semiconductor unit on the basis of silicon is carried out by dipping the semiconductor unit into an etching bath of diluted hydrofluoric acid. Other methods of applying hydrofluoric acid onto the semiconductor may also be used.

In addition to etching other cleaning processes may be carried out during the cleaning step, like rinsing of the etched semiconductor unit with water, especially de-ionized water. By rinsing loosely adhered material undetached during etching may be removed.

After preparing of the surface of a semiconductor unit by the cleaning step, a drying step is carried out before deposition of the passivation layer and/or anti-reflection coating. According to the present invention, the drying step is performed in a substantially oxygen-free or at least oxygen-depleted environment in order to avoid re-oxidation of the surface. If re-oxidation is prevented, a more effective passivation of the semiconductor unit can be achieved in the following deposition step. In particular, it was found out that it is possible to introduce a much higher amount of hydrogen into the passivation layer or anti-reflection coating as well as into the semiconductor unit, in particular into multi- or poly-crystalline silicon, as it is possible according to the prior art. As described in the PhD thesis of W. Wolke, University Freiburg im Breisgau, November 2005 an increase of the hydrogen content exceeding an optimum value leads to blistering and formation of microscopic bubbles at the interface between the silicon semiconductor unit and the passivation layer. However, if the drying step according to the present invention is carried out in an oxygen-free environment before deposition of the passivation layer and/or anti-reflection coating, a blistering can be avoided and the hydrogen content can be further increased.

Compared to the prior art described in US 4,705,760 the preparation of the surface according to the present invention is quite simple and not affected by complex and expensive plasma treatment.

The drying step in an oxygen-free or oxygen-reduced environment can be performed in various ways. One possibility is flushing of the semiconductor unit with at least one dry inert gas like argon, helium, nitrogen and/or neon in a gastight treating chamber. However, other drying processes which can be carried out without oxygen are conceivable. For example, the ambient pressure may be reduced so that moisture and liquid substances may evaporate. The pressure may be reduced down to the level of high vacuum, namely down to 10⁻⁷ mbar or at least 10⁻³ mbar.

In addition or alternatively, the temperature may be raised in order to support evaporation and therefore drying. This heat treatment may be carried out at temperatures up to 500°C, preferably up to 700°C. The evaporated contaminations may be exhausted from a treating chamber by suction pump means or vacuum pump means. Moreover, the evaporated contaminations may be led away from the semiconductor unit by the gas flow produced by inert gases as mentioned above.

A further possibility for evaporation of contaminations is exposure of the semiconductor unit to microwaves.

The gases supplied to a treating chamber, wherein the drying step is performed, like gas used for producing a gas flow at the semiconductor unit, may be treated to remove or to reduce residual oxygen contents. Alternatively or in addition, this may be performed for the gas being present in the treating chamber from time to time or continuously during the drying step. For this purpose, the gas may be circulated.

The deposition step by which a passivation layer is deposited on the surface of the semiconductor unit may be carried out by a cathode evaporation process also called sputtering. Preferably, the sputtering is performed as reactive sputtering which means that at least one reactive gas is introduced into the vacuum chamber where reactive sputtering is performed. The reactive gas reacts with the material atomized by sputtering and forms the composition to be deposited on the substrate. For the present invention a mixture of nitrogen and ammonia gas may be used as a reactive gas mixture while argon may be used as a process gas for the sputtering. Preferably, silicon is used as the target material for the sputtering, i.e. that silicon atoms are produced by the sputtering process. Silicon atoms may form together with the nitrogen silicon nitride to be deposited at the semiconductor unit. Due to the presence of ammonia gas hydrogen is produced in the reaction chamber so that hydrogen is incorporated in the silicon nitride layer as well as in the semiconductor unit by diffusion processes. Due to the reaction of nitrogen and hydrogen to ammonia and vice versa utilization of a mixture of nitrogen and ammonia gas as reactive gas mixture allows to define the hydrogen content in the deposited layer as well as in the semiconductor unit.

Accordingly, the composition of the reactive gas mixture, namely the ratio of nitrogen and ammonia may not only be varied according to the hydrogen content desired in the deposited layer and/or the semiconductor unit, but the composition may also be varied during deposition so that the composition of the layer at least with respect to hydrogen content is varying in the thickness direction.

Since sputtering as well as reactive sputtering are leading to very homogeneous layers, the deviation of the layer thickness may be below 1.5 % over the whole surface.

A further advantage of sputter deposition is that the sputter deposition can be carried out continuously in an inline coating apparatus. Thus, the inventive method and especially the deposition step can be performed very efficiently.

The silicon nitride layer and especially the hydrogenated silicon nitride layer preferably deposited as passivation layer can additionally be designed as an anti-reflection coating. Accordingly, the thickness of the passivation layer has to be set such that due to a smart design of the interfaces and boundary layers multiple reflection occurs which at the end leads to a reduced reflection of light at the surface of the semiconductor unit.

Preferably, the cleaning step, the drying step and the deposition step may be carried out such that the semiconductor unit is not exposed to an oxygen containing atmosphere during or between the treatment steps. Preferably, the cleaning step, the drying step and the deposition step can be carried out in a sequence, wherein the steps are performed one after the other in a successive row.

This allows also for an advantageous design of an apparatus for carrying out the inventive method which comprises appropriate treating chambers for carrying out the cleaning step, the drying step and the deposition step. These chambers can be arranged one after the other in a row so that the semiconductor unit to be treated can be moved through the treating chambers one after the other and run through the different treatments.

Such an apparatus may have separate treating chambers for the different treating steps which may be shut against the others so that different atmospheres can be set up in the treating chambers. In this case, lock units may be provided for between the treating chambers as well as at the inlet and the outlet of the apparatus.

A photovoltaic device produced by the inventive method has an increased hydrogen content which again increases efficiency of the photovoltaic device.

### SHORT DESCRIPTION OF THE FIGURES

Further advantageous, features and characteristics of the present invention will become apparent from the following description of embodiments of the invention. The embodiments are described with respect to the drawings which only schematically show in
- Fig. 1: a perspective view of a part of a solar cell produced according to the present invention;
- Fig. 2: an illustration of an apparatus for carrying out the present invention; and in
- Fig. 3: an illustration of the vacuum chamber for sputter depositing contained in the apparatus of fig. 2.

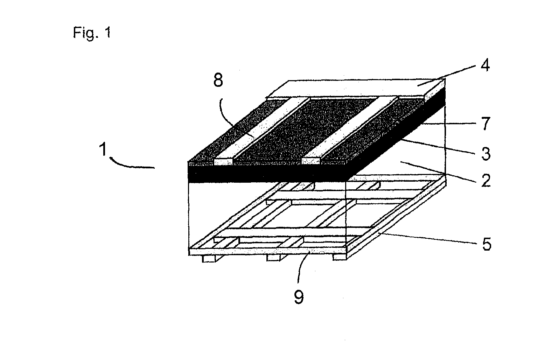

Fig. 1 shows a perspective view of a solar cell produced according to the present invention. The solar cell 1 comprises a semiconductor unit formed by two semiconductor layers 2 and 3 having different types of conductivity. For example, the semiconductor layer 3 has a n-type conductivity and forms the emitter of the semiconductor unit 2, 3. The other semiconductor layer 2 having a p-type conductivity accordingly represents the basis of the semiconductor junction formed by the semiconductor layers 2 and 3.

At the side of the emitter 3, which is the side of the semiconductor unit 2, 3 where light is impinging onto the solar cell 1, an anti-reflection coating or passivation layer 7 is provided for.

The passivation layer or anti-reflection coating 7 is made of hydrogenated silicon nitride and comprises one or several separately deposited layers. Thus, coating is designed such which respect to its thickness that light with a wavelength range of sunlight is almost not reflected. This can be achieved by destructive interference or multiple reflection of the partial light beams reflected at the different interfaces between the single layers. Thus, the reflection of impinging light can be reduced or almost prevented.

On top of the passivation layer or anti-reflection coating 7 conduction paths 8 formed by a metal grid as well as contact electrodes 4 are provided for.

The backside of the photovoltaic device in form of the solar cell 1 shown in fig. 1 is covered by a metal layer 9 and a counter electrode 5 formed by an additional metal grid.

Instead of the metal grid 8 provided at the front side (light side) of the solar cell 1 a transparent conductive layer made of indium tin oxide or the like may be arranged at the surface similar to the metal layer 9 of the backside contact.

In addition to the anti-reflection coating 7 at the front side (light side) of the solar cell, i.e. the main surface of the emitter layer 3, the front side may be structured so that a hill structure with a plurality of pyramidal projections and/or indentations is formed. Such a structure also leads to reduced reflection of impinging light.

The passivation layer or anti-reflection coating 7 was produced according to the present invention. Since the main surface of the emitter layer 3 was dried in an oxygen-free environment, a high content of hydrogen could be introduced into the passivation layer 7 made of hydrogenated silicon nitride as well as in the underlying emitter layer 3 made of a n-doped multi-crystalline silicon after the cleaning step. The hydrogen contained in the passivation layer as well as at the interface between the passivation layer and the emitter layer 3 leads to a reduction of locations for recombination of the charge carrier produced by the impinging light. This is also true for the hydrogen contained in the multi-crystalline silicon of the emitter layer 3 or of the basis 2. Since the grain boundaries of the multi-crystalline silicon also provide recombination locations for the charge carrier the hydrogen may reduce such recombination locations at the grain boundaries.

Due to the drying step without oxygen being present in the environment, it is possible to introduce more hydrogen into the passivation layer 7 as well as into the multi-crystalline silicon of the emitter 3 and the basis 2 by the depositing step carried out by sputter deposition. Accordingly, the efficiency of the solar cell 1 is significantly increased.

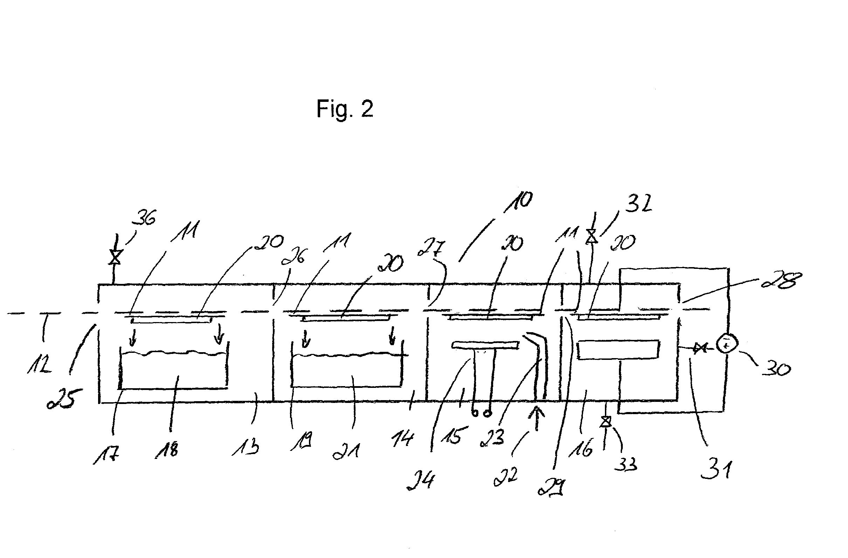

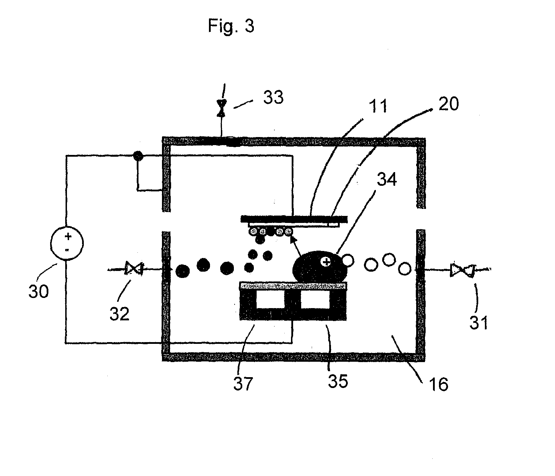

The inventive method is further described with respect to figs. 2 and 3 showing an apparatus for carrying out the inventive method.

Fig. 2 shows a schematic side view of an apparatus 10 for carrying out the inventive method.

This apparatus 10 is designed as a continuously working production line with a transport path 12 for the substrates 20 being placed on a substrate carrier 11.

Along the transport path 12 different treating chambers 13, 14, 15 and 16 are arranged side-by-side.

The treating chambers 13 to 16 are designed as vacuum chambers which are gastight so as to allow an oxygen-free atmosphere during the whole production process.

While during the first cleaning step carried out in the treating chambers 13 and 14 an oxygen-free atmosphere is not necessary at least for the partial process in chamber 13, it is advantageous to exclude oxygen during these processes, too.

The cleaning step of the inventive method is carried out in the treating chambers 13 and 14. The cleaning step comprises two partial steps of chemically wet etching in treating chamber 13 and rinsing of the substrate 20 or the semiconductor unit, respectively, by de-ionized water in treating chamber 14.

Accordingly, treating chamber 13 comprises an acid tank 17 containing the diluted hydrofluoric acid for chemically wet etching of the semiconductor unit 2, 3 at the main surface of the emitter layer 3. The etching is performed by lowering down of the substrate 20 into the acid bath 17, 18 as indicated by the two arrows of fig. 2.

After etching of the substrate 20 formed by the semiconductor unit 2, 3, the substrate 20 is transferred to treating chamber 14 wherein the second partial step of the cleaning step, namely rinsing of the semiconductor unit 2, 3 in de-ionized water is performed.

Accordingly, treating chamber 14 also includes a tank 19 wherein de-ionized water is stored. The substrate 20 is again lowered down into the de-ionized water as indicated by the arrows of fig. 2.

After finishing of the cleaning step the substrate 20 is moved by the substrate carrier 11 along the transport path 12 to the next treating chamber 15, wherein the drying step is carried out.

According to the present invention, the drying step is carried out without presence of oxygen. Therefore, the vacuum chambers 13 to 16 used as a treating chambers 13 to 16 do substantially not contain oxygen. In order to provide a gas flow for drying, treating chamber 15 comprises a gas supply 23 by which a dry inert gas 22 can be introduced into the treating chamber 15 and guided by guiding means like nozzles (not shown) of the gas supply 23 towards the surface of the substrate 20 to achieve a gas flow along the surface of the substrate or the surface of the emitter layer 3, respectively. Due to the gas flow, water, moisture or other materials, like organic material originating from the preceding cleaning step may be absorbed by the gas flow of a dry inert gas and transported to an outlet of the vacuum chamber or treating chamber 15 (not shown).

In order to facilitate removal of the contaminations adhering to the emitter surface or substrate surface, respectively, the temperature of the substrate 20 or of the interior space of the treating chamber 15 may be increased in order to improve evaporation of the contaminations. For this purpose heating means 24 like resistance heating means may be arranged inside the treating chamber 15.

After drying in the treating chamber 15 the substrate 20 is carried by the substrate carrier 11 to the treating or vacuum chamber 16 wherein a sputter deposition of the passivation layer or anti-reflection coating is performed.

The treating chamber 16 is also shown in fig. 3 for illustrating more details.

Treating chamber or vacuum chamber 16 is designed as an apparatus for reactive sputtering. Accordingly, the treating chamber 16 comprises a magnetron electrode 36 used as the cathode. The magnetron electrode 37 comprises a silicon target which is atomized by the impinging argon ions of the plasma 34 generated in front of the magnetron electrode 37. The plasma 34 can be ignited by a separate microwave source (not shown) or by a radio frequency voltage (RF voltage) applied at the magnetron electrode 37 as well as the counter electrode formed by the substrate carrier 11. For this purpose a power source 30 is provided for.

In order to supply argon as a process gas for the sputter deposition into the treating chamber 16, a gas supply 31 is arranged at the treating chamber 16.

A second gas supply 32 is used for supplying the reaction gases for the reactive sputtering. In a preferred embodiment of the present invention the reaction gas supplied by the gas supply 32 is a mixture of nitrogen and ammonia gas so as to provide nitrogen and hydrogen for deposition on the substrate 20. Together with the silicon atoms produced by the atomization of the silicon target during sputtering the nitrogen forms silicon nitride. The hydrogen present in the gas phase of treating chamber 16 is incorporated into the silicon nitride layer to form hydrogenated silicon nitride. In addition, the hydrogen may diffuse into the substrate 20, i.e. the emitter 3 and basis 2 of the semiconductor unit forming the substrate 20. Due to the ratio of the mixture of nitrogen and ammonia gas the amount of hydrogen, which is able to be incorporated into the silicon nitride as well as into the multi-crystalline silicon of the semiconductor unit 2, 3, may be set. Accordingly, it is possible by the inventive method to determine the hydrogen content of the multi-crystalline silicon of the semiconductor unit 2, 3 as well as of the silicon nitride layer deposited as the passivation layer on top of the semiconductor unit. Accordingly, it is possible to increase the hydrogen content and to reduce the recombination locations for the charge carrier within the semiconductor unit as well as at the interface between the passivation layer and the semiconductor unit. This again leads to an increased efficiency of a solar cell produced by this method.

Although, the present invention is described in detail with respect to the embodiments, it is evident for a man skilled in the art, that the invention is not restricted to these embodiments, but modifications and amendments are possible, with respect to a different combination of all the features disclosed in the specification or by omitting one of the features of the embodiments without leaving the scope of the present invention which is defined by the attached claims. In particular, the present invention comprises all possible combinations of all claims, even if single claims are only referred to other single claims.

## Claims

1. A method of producing a photovoltaic device having at least one semiconductor unit comprising the following steps:
- cleaning of at least one surface of the semiconductor unit by etching,
- drying of the at least one surface of the semiconductor unit in a substantially oxygen-free or oxygen-depleted environment and
- depositing of a passivation layer on the at least one surface.

2. A method according to claim 1,
**wherein**
the cleaning step, the drying step and the deposition step are carried out in a sequence during which the semiconductor unit is arranged in a substantially oxygen-free atmosphere.

3. A method according to claim 1,
**wherein**
the semiconductor unit comprises at least a first area of a first conductivity type and at least a second area of a second conductivity type forming at least one semiconductor junction between first and second area.

4. A method according to claim 1,
**wherein**
the cleaning step is carried out by at least one method selected from the group comprising chemical dry etching, chemical wet etching, physical etching, ion beam etching and plasma etching.

5. A method according to claim 1,
**wherein**
the cleaning step comprises an etching bath in diluted hydrofluoric acid.

6. A method according to claim 1,
**wherein**
the cleaning step comprises rinsing in de-ionized water.

7. A method according to claim 1,
**wherein** the drying step comprises flushing the semiconductor unit with at least one dry inert gas selected from the group comprising argon, helium, nitrogen and neon.

8. A method according to claim 1,
**wherein**
the drying step comprises reducing the ambient pressure in a vacuum chamber to a pressure between near vacuum and a pressure below atmosphere.

9. A method according to claim 1,
**wherein**
the drying step comprises reducing the ambient pressure in a vacuum chamber down to a pressure of 10⁻⁷ mbar.

10. A method according to claim 1,
**wherein**
the drying step comprises heating of the semiconductor unit to a temperature above ambient temperature.

11. A method according to claim 1,
**wherein**
the drying step comprises heating of the semiconductor unit up to a temperature of 700°C.

12. A method according to claim 1,
**wherein**
the drying step comprises an exposure of the semiconductor unit to microwaves.

13. A method according to claim 1,
**wherein**
the drying step comprises a procedure for reducing oxygen content in gas supplied to or being present in an airtight chamber in which the semiconductor unit is located during drying.

14. A method according to claim 1,
**wherein**
the deposition step comprises deposition by sputtering.

15. A method according to claim 1,
**wherein**
the deposition step is carried out by reactive sputtering.

16. A method according to claim 1,
**wherein**
the deposition step is carried out by reactive sputtering using nitrogen and ammonia gas (NH₃) as reactive gas mixture and argon as process gas.

17. A method according to claim 1,
**wherein**
the deposition step is carried out by reactive sputtering using nitrogen and ammonia gas (NH₃) as reactive gas mixture, the composition of the reactive gas mixture being set to define hydrogen content of the deposited layer.

18. A method according to claim 1,
**wherein**
the deposition step is carried out by reactive sputtering using nitrogen and ammonia gas (NH₃) as reactive gas mixture, the composition of the reactive gas mixture being set to be between 1:99 and 99:1 for the ratio of N:NH₃.

19. A method according to claim 1,
**wherein**
the deposition step is carried out by reactive sputtering using nitrogen and ammonia gas (NH₃) as reactive gas mixture, the composition of the reactive gas mixture being varied during deposition.

20. A method according to claim 1,
**wherein**
the deposition step is carried out continuously in an in-line coating apparatus.

21. A method according to claim 1,
**wherein**
the deposition step is carried out in a vacuum chamber wherein a pressure between 0,1 and 15 µbar is set.

22. A method according to claim 1,
**wherein**
as passivation layer hydrogen containing silicon nitride is deposited.

23. A method according to claim 1,
**wherein**
the passivation layer is designed as an anti-reflection coating (ARC).

24. A method according to claim 1,
**wherein**
the cleaning step, the drying step and the depositing step are carried out at the same surface being at a side of the semiconductor unit which is designed to be exposed to light.

25. A method according to claim 1,
**wherein**
the semiconductor unit comprises one out of doped and un-doped single-crystalline and multi-crystalline silicon.

26. An apparatus for producing a photovoltaic device with at least one semiconductor unit comprising:
- at least one cleaning chamber for cleaning of at least one surface of the semiconductor unit by etching,
- at least one drying chamber for drying of the at least one surface of the semiconductor unit in a substantially oxygen-free or oxygen-depleted environment and
- at least one deposition chamber for depositing of a passivation layer on the at least one surface by sputtering,
wherein the cleaning chamber, the drying chamber and the deposition chamber are arranged in line to be passed by the semiconductor unit one after the other in a closed, oxygen-free atmosphere.

27. A photovoltaic device comprising a
semiconductor unit;
a passivation layer deposited on the semiconductor unit;
the semiconductor unit and the passivation layer comprising hydrogen,
**wherein**
the hydrogen content in at least one of the semiconductor unit and the passivation layer is equal or above 15 at.%.

28. A photovoltaic device according to claim 27,
**wherein**
the hydrogen content in at least one of the semiconductor unit and the passivation layer is equal or above 15 at.%.

29. A photovoltaic device according to claim 27,
**wherein** the hydrogen content in at least one of the semiconductor unit and the passivation layer is equal or above 20 at.%.

30. A photovoltaic device according to claim 27,
**wherein**
the hydrogen content in at least one of the semiconductor unit and the passivation layer is equal or above 25 at.%.

31. A photovoltaic device comprising a
semiconductor unit;
a passivation layer deposited on the semiconductor unit;
the semiconductor unit and the passivation layer comprising hydrogen,
wherein
the semiconductor unit has an efficiency of at least 10 %.

32. A photovoltaic device according to claim 31,
**wherein**
the semiconductor unit has an efficiency of at least 15 %.

33. A photovoltaic device according to claim 31,
**wherein**
the semiconductor unit has an efficiency of at least 20 %.
